# EUROPEAN PATENT APPLICATION

(11) **EP 3 456 963 A1**
(43) Date of publication of application: **20.03.2019**
(21) Application number: 18194367.1
(22) Date of filing: 13.09.2018
(51) Int. Cl.: F04B 17/04, F04B 43/00, F04B 43/04, F04B 49/02, F04B 49/06, F04B 13/00, F04B 49/10

(54) **SOLENOID CURRENT MONITORING METHOD AND PUMPING SYSTEM FOR DETECTING A LOSS OF PRIME CONDITION**

(30) Priority: 14.09.2017 US 201762558473 P; 28.11.2017 US 201715824784
(71) Applicant: Milton Roy, LLC, Ivyland, PA 18974 (US)
(72) Inventor: Carman, Jason, Gardner, KS 66030 (US); Fairfield, Nile, Prairie Village, KS 66208 (US)
(74) Representative: Samson & Partner Patentanwälte mbB

(57) **Abstract**

A metering pump is typically used to move a specified volume of liquid in a specified amount of time. Because it may be desirable to maintain fluid in the pumping system such that the metering pump is maintained in a primed condition, an automatic prime detection function is provided by monitoring the current to a solenoid assembly of the pump. A loss of prime condition can then be detected by comparing the measured current to a characterized selected current value such that operation of the metering pump can be changed based on load.

## Description

### CROSS REFERENCE TO RELATED INFORMATION

This application claims the benefit of U.S. Provisional Patent Application No. 62/558,473, filed September 14, 2017, titled "Solenoid Current Monitoring Method for Leak Detection and Vapor Lock", the contents of which are hereby incorporated herein in its entirety.

### TECHNICAL FIELD

The present disclosure is directed to an apparatus and method to detect a loss of prime condition for a metering pump.

### BACKGROUND OF THE INVENTION

Metering pumps are typically used to move a specified volume of liquid in a specified time to provide an accurate flow rate. Many precision metering pumps use a flexible diaphragm mechanism and checkball configuration to transfer fluid from a source tank to a process fluid tank for treatment. During a suction stroke, the diaphragm and checkball(s) generally create a negative pressure scenario that lifts the fluid from the source tank into the suction tube toward the suction end of the pump. During the discharge stroke, the diaphragm and checkball(s) generally create a positive pressure differential to move the fluid towards the discharge end of the pump. The amount and speed of fluid movement through the tubing is primarily dependent on the diaphragm displacement during each stroke cycle and the rate of cycling the diaphragm between suction and discharge positions. Such metering pumps can pump chemicals, solutions, or other liquids.

The initial priming sequence of the pump is the process of filling the injection tubing with fluid. Typically, this process takes several pumping cycles to fill the tubing adequately prior to being able to inject fluid into the process fluid tank. In some instances, diaphragm metering pumps may be subject to a loss of prime condition where the tubing is not filled with liquid, and air or gas has built up in the cavity. During a loss of prime condition, the pressure vacuum in the tubing may be lost and the fluid may reverse flow from the tubing back into the source tank. This may particularly occur in low duty cycle pumping applications or if the pump is turned off for an extended amount of time. When prime is lost in the system, the air can be removed and replaced with liquid to re-prime the system through suction/discharge strokes of the metering pump. However, this re-priming requires manual intervention, and may be time consuming and may result in under treating the process fluid. Accordingly, there is a need to provide an easier and more efficient method to detect a loss of prime condition for metering pumps.

### BRIEF SUMMARY OF THE INVENTION

A priming detection function is provided to determine whether the metering pump is in a state to actively pump fluid to safeguard against under treatment conditions.

In one embodiment, a method for detecting a loss of prime condition in a pumping system may comprise characterizing at least one waveform characteristic of the current to a solenoid assembly that actuates a pump of the pumping system; determining a selected current value needed to operate the solenoid assembly based on the characterized waveform; measuring a current to the solenoid assembly; and comparing the measured current to the selected current value. The at least one waveform characteristic may comprise one or more of a shape, an amplitude, a period, a noise level, and a slope of the measured current. Characterizing the at least one waveform characteristic may comprise: setting a selected pump load to operate the solenoid assembly at a desired level; measuring the current to the solenoid assembly to determine a selected current value; and storing the measured data in a control assembly. A loss of prime condition may be detected when the measured current is below the selected current value. The pump may initiate a priming mode when the loss of prime condition is detected. The priming mode may comprise actuating the pump at an elevated speed for a selected amount of time. The pump may be operated in an alert mode when the loss of prime condition is detected by selecting one or more of stopping the pump and issuing a warning that the loss of prime condition has occurred. The pump may continue normal operation when the measured current is at or above the selected current value.

In another embodiment, a method for operating a pump that comprises a solenoid assembly for actuating the pump may comprise: measuring a current of the solenoid assembly; determining whether the measured current exceeds a selected current value; and operating the pump based on whether the measured current exceeds the selected current value. The pump may continue normal operation of the pump if the measured current exceeds the selected current value. The pump may initiate a priming mode if the measured current does not exceed the selected current value. It may be determined whether the measured current exceeds the selected current value after operating the pump in the priming mode. The pump may revert to normal operation if the measured current exceeds the selected current value after operating the pump in the priming mode. The pump may initiate an alert mode if the measured current does not exceed the selected current value after operating the pump in the priming mode by selecting one or more of stopping the pump and issuing a warning that the loss of prime condition has occurred.

In another embodiment, a pumping system may comprise: an electronic power unit comprising a solenoid assembly and a clapper assembly; a diaphragm coupled to the electronic power unit, wherein the diaphragm is operable to pump fluid when the diaphragm is actuated by the electronic power unit; and a control assembly coupled with the electronic power unit, wherein the control assembly is operable to actuate the electronic power unit; wherein the control assembly is programmed to detect a loss of prime condition in the pumping system by measuring a current to the solenoid assembly. The control assembly may be programmed to detect the loss of prime condition by comparing the measured current to a selected current value needed to actuate the solenoid assembly. The control assembly may be programmed to actuate the pump based on whether the loss of prime condition is detected. The control assembly may be programmed to actuate the pump at a maximum capacity when the loss of prime condition is detected. A current monitoring circuit may be operable to measure the current to the solenoid assembly. The current monitoring circuit may comprise a resistor, wherein the monitoring circuit is operable to measure the current supplied to the solenoid assembly through the resistor.

The foregoing has outlined rather broadly the features and technical advantages of the present invention in order that the detailed description of the invention that follows may be better understood. Additional features and advantages of the invention will be described hereinafter which form the subject of the claims of the invention. It should be appreciated by those skilled in the art that the conception and specific embodiment disclosed may be readily utilized as a basis for modifying or designing other structures for carrying out the same purposes of the present invention. It should also be realized by those skilled in the art that such equivalent constructions do not depart from the spirit and scope of the invention as set forth in the appended claims. The novel features which are believed to be characteristic of the invention, both as to its organization and method of operation, together with further objects and advantages will be better understood from the following description when considered in connection with the accompanying figures. It is to be expressly understood, however, that each of the figures is provided for the purpose of illustration and description only and is not intended as a definition of the limits of the present invention.

### BRIEF DESCRIPTION OF THE DRAWINGS

For a more complete understanding of the present invention, reference is now made to the following descriptions taken in conjunction with the accompanying drawings, in which:
FIG. 1A depicts a schematic of a metering pump system.
FIG. 1B depicts a schematic of the metering pump system of FIG. 1 in a primed configuration.
FIG. 2 depicts a top perspective view of a metering pump of the metering pump system of FIG. 1A.
FIG. 3 depicts a front view of the metering pump of FIG. 2.
FIG. 4 depicts a cross-sectional view of the metering pump of FIG. 2 taken along line 4-4 of FIG. 3.
FIG. 5 depicts an exploded view of a control panel assembly of the metering pump of FIG. 2.
FIG. 6 depicts a front view of the control panel assembly of FIG. 5.
FIG. 7 depicts a cross-sectional view of the control panel assembly of FIG. 5 taken along line 7-7 of FIG. 6.
FIG. 8 depicts an exploded view of a housing assembly of the metering pump of FIG. 2, with an electronic power unit (EPU) assembly removed.
FIG. 9 depicts a front view of the housing assembly of FIG. 8, with the EPU assembly assembled with the housing assembly.
FIG. 10 depicts a cross-sectional view of the housing assembly of FIG. 8 taken along line 10-10 of FIG. 9, with the EPU assembly assembled with the housing assembly.
FIG. 11 depicts a top perspective view of the EPU assembly of FIG. 8.
FIG. 12 depicts an exploded view of a solenoid assembly of the EPU assembly of FIG. 8, with a clapper assembly removed.
FIG. 13 depicts a front view of the EPU assembly of FIG. 8.
FIG. 14 depicts a cross-sectional view of the EPU assembly of FIG. 8 taken along line 14-14 of FIG. 13.
FIG. 15 depicts a rear perspective view of the clapper assembly FIG. 12.
FIG. 16 depicts a front exploded view of the clapper assembly of FIG. 15.
FIG. 17 depicts a front view of the clapper assembly of FIG. 15.
FIG. 18 depicts a cross-sectional view of the clapper assembly of FIG. 15 taken along line 18-18 of FIG. 17.
FIG. 19 depicts a top perspective view of another metering pump that can be incorporated with the metering pump system of FIG. 1A.
FIG. 20 depicts a front view of the metering pump of FIG. 19.
FIG. 21 depicts a cross-sectional view of the metering pump of FIG. 19 taken along line 21-21 of FIG. 20.
FIG. 22 depicts a cross-sectional view of the metering pump system of FIG. 1A.
FIG. 23 depicts a schematic of a priming sequence of the metering pump system of FIG. 1A.
FIG. 24 depicts a schematic of a current monitoring circuit for use with the metering pump system of FIG. 1A.
FIG. 25 depicts a diagram of a motor current waveform that may be detected by the current monitoring circuit of FIG. 24.
FIG. 26 depicts a schematic of a motor current comparison sequence for use with the metering pump system of FIG. 1A.
FIG. 27 depicts a schematic of a pump priming detection sequence for use with the metering pump system of FIG. 1A.
FIG. 28 depicts a diagram of a loaded current waveform that may be detected by the current monitoring circuit of FIG. 24.
FIG. 29 depicts a diagram of an unloaded current waveform that may be detected by the current monitoring circuit of FIG. 24.

### DETAILED DESCRIPTION OF THE INVENTION

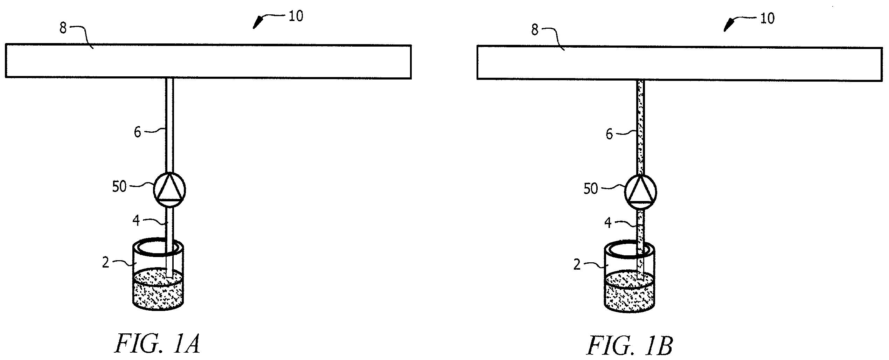

Referring now to Figure 1A, an exemplary system using a metering pump is described. Metering pump system (10) for pumping a specified volume of liquid in a specified time includes a storage tank (2), a metering pump (50), and a process fluid tank (8). The metering pump (50) is fluidly coupled with the storage tank (2) by suction tubing (4), and the metering pump (50) is fluidly coupled with the process fluid tank (8) by injection tubing (6). Accordingly, the metering pump (50) can be operated to pump fluid from the storage tank (2) to the process fluid tank (8), as shown in FIG. 1B, in a specified time at a desired flow rate. The initial priming sequence of the pump (50) is the process of filling the tubing (4, 6) with fluid to a primed condition shown in FIG. IB. Typically, this process takes several pumping cycles to fill the tubing (4, 6) adequately prior to being able to inject fluid into the process fluid tank (8). Although any type of metering pump can be incorporated into the metering pump system (10) to pump any type of fluid (i.e., chemicals, solutions, water, etc.), a diaphragm metering pump will be discussed in more detail below.

### I. An Embodiment of a Diaphragm Metering Pump

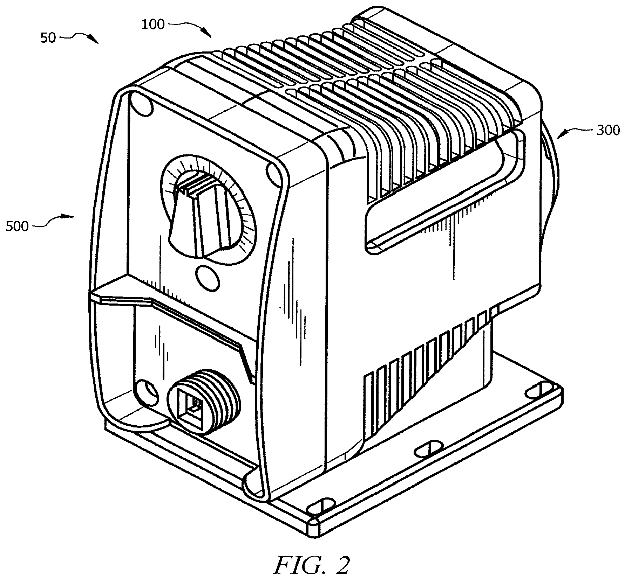

An embodiment of a diaphragm metering pump (50) is shown in FIGS. 2-4. In the illustrated embodiment, the metering pump (50) comprises a control panel assembly (500) coupled to an electronic power unit (EPU) assembly (300) positioned within a housing (100). Each of these components will be described in more detail below.

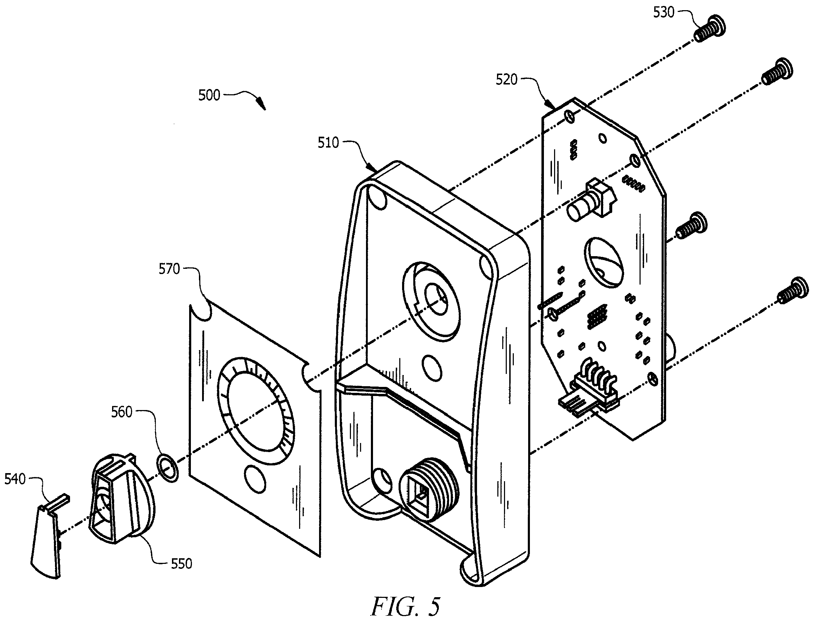

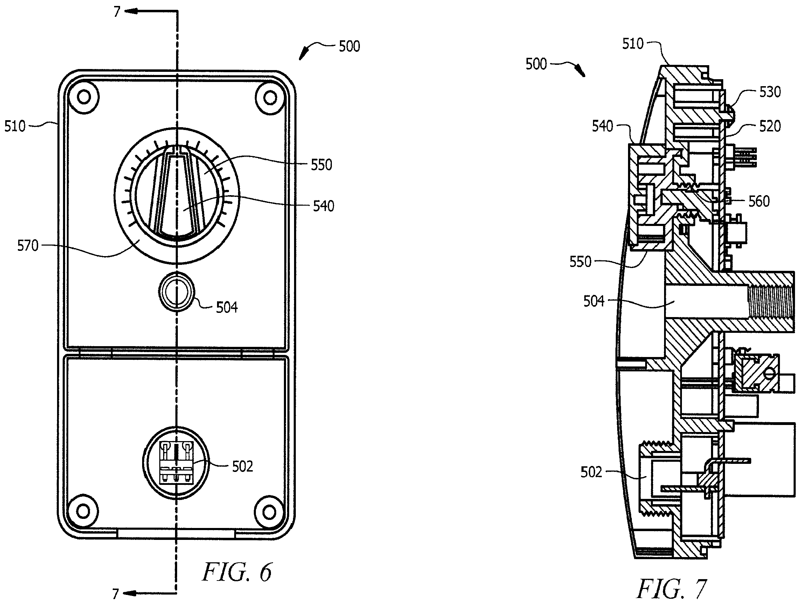

As best seen in FIGS. 5-7, the control panel assembly (500) comprises a printed circuit board (PCB) assembly (520) to selectively control actuation of the pump (50). The PCB assembly (520) is coupled to rear surface of a control panel (510) by fasteners (530). A pointer (540), a speed control knob (550), a nameplate (570), and a power input (502) are positioned on a front surface of the control panel (510). The nameplate (570) in the illustrated embodiment displays adjustable speed settings for the pump (50). The pointer (540) and speed control knob (550) are then positioned over the nameplate (570) and coupled to the PCB assembly (520) through the control panel (510) with O-ring (560). Accordingly, a user can turn the speed control knob (550) to adjust the speed of the pump (50). The pointer (540) is configured to turn with the speed control knob (550) to indicate the selected speed setting on the nameplate (570). Still other suitable configurations for adjusting the speed of the pump (50) will be apparent to one with ordinary skill in the art in view of the teachings herein. An opening (504) is also defined by the control panel assembly (500) to allow a user to adjust the stroke length of the pump (50), which will be discussed in more detail below. A power source can be connected with the power input (502) of the control panel assembly (500) to provide power to the control panel assembly (500) and/or the EPU assembly (300). In some instances, the pump (50) is battery operated such that the power input (502) is merely optional. Other suitable configurations for the control panel assembly (500) will be apparent to one with ordinary skill in the art in view of the teachings herein.

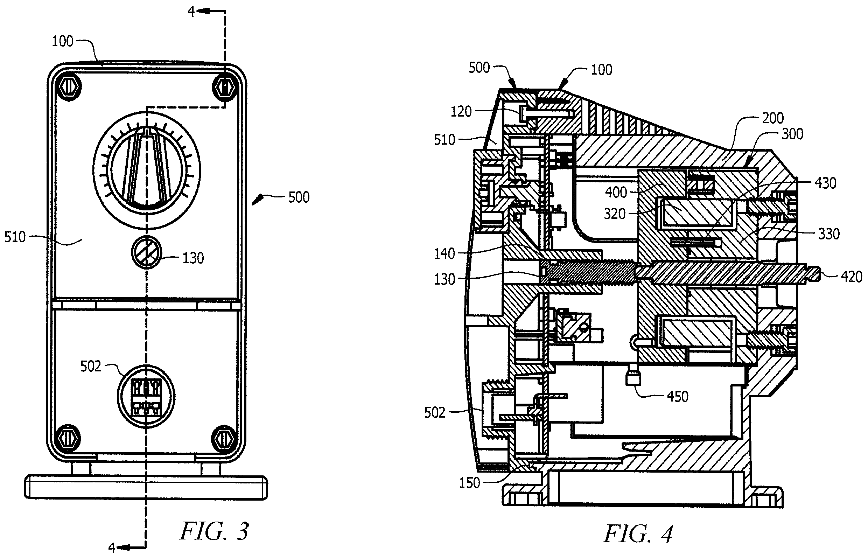

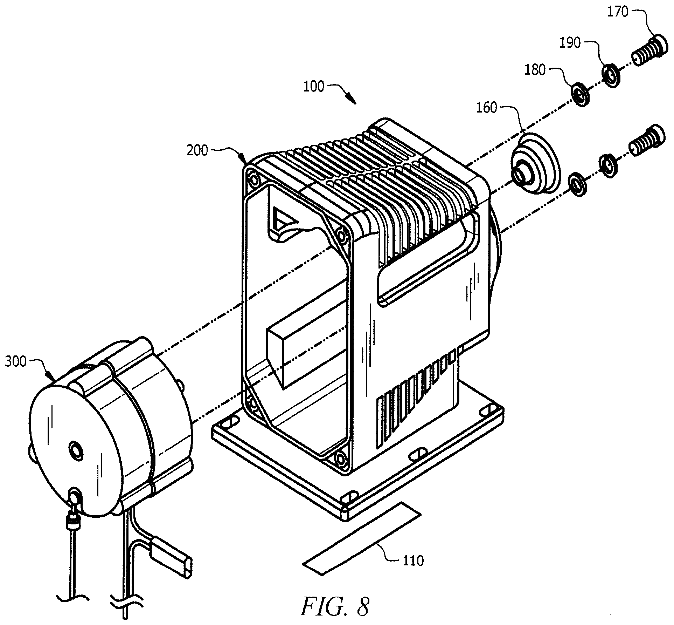

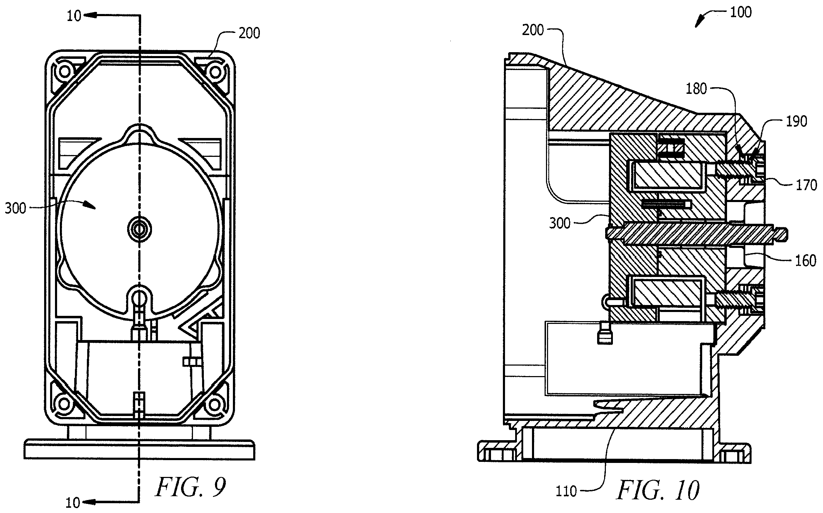

The housing of the pump (50), as shown in FIGS. 4 and 8-10, comprises a cover (200) for housing the EPU assembly (300) and is coupled to a rear surface of the control panel assembly (500) by fasteners (120). A stroke length adjustment screw (130) is positioned within the opening (504) of the control panel assembly (500) such that threads of the screw (130) correspond to the threads of the opening (504). A user can thereby insert a tool, such as a screwdriver, through the opening (504) to turn the screw (130) relative to the control panel assembly (500) to adjust the stroke length of the pump (50). Still other suitable configurations for adjusting the stroke length will be apparent to one with ordinary skill in the art in view of the teachings herein. The EPU assembly (300) is coupled with the cover (200) with fasteners (170, 180, 190) and sealed with O-rings (140, 150) and a seal (160) at the rear surface of the cover (200). A label (110) can optionally be adhered or coupled to a surface of the housing (100) to provide identifying information for the pump (50). Other suitable configurations for the housing (100) will be apparent to one with ordinary skill in the art in view of the teachings herein.

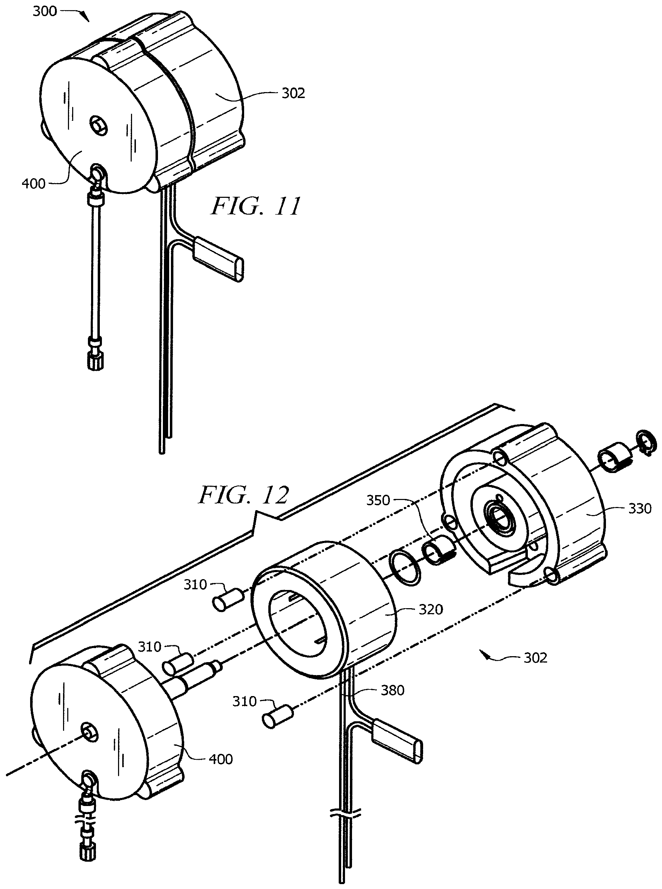

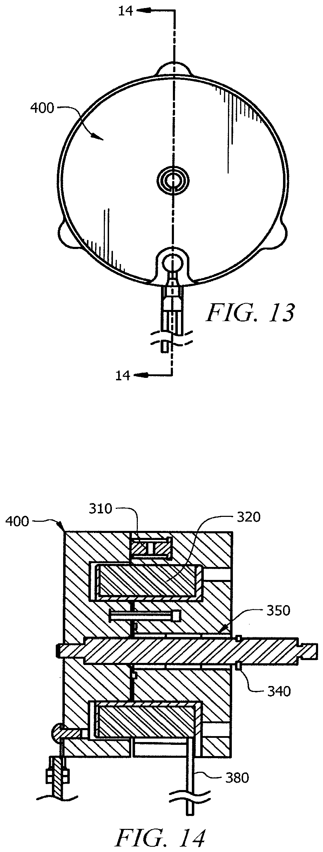

Referring to FIGS. 11-14, the EPU assembly (300) comprises a clapper assembly (400) coupled with a solenoid assembly (302). The solenoid assembly (302) comprises a coil (320) inserted within a pole piece (330). The coil (320) is coupled to the PCB assembly (520) of the control panel assembly (500) by wiring (380). The PCB assembly (520) can thereby send pulses of electrical energy to the coil (320) to selectively activate the solenoid assembly (302). For instance, when the coil (320) is activated, it produces a magnetic field that is directed to the clapper assembly (400) by the pole piece (330). Accordingly, the solenoid assembly (302) is selectively activated to reciprocate the clapper assembly (400) forward and backward relative to the solenoid assembly (302). In the illustrated embodiment, at least one spring and pad assembly (310) is positioned between the clapper assembly (400) and the solenoid assembly (302) to relieve the impact of the clapper assembly (400) against the solenoid assembly (302). A bushing (350) is also positioned around a shaft (420) of the clapper assembly (400) to reduce friction as the clapper assembly (400) translates relative to the solenoid assembly (302).

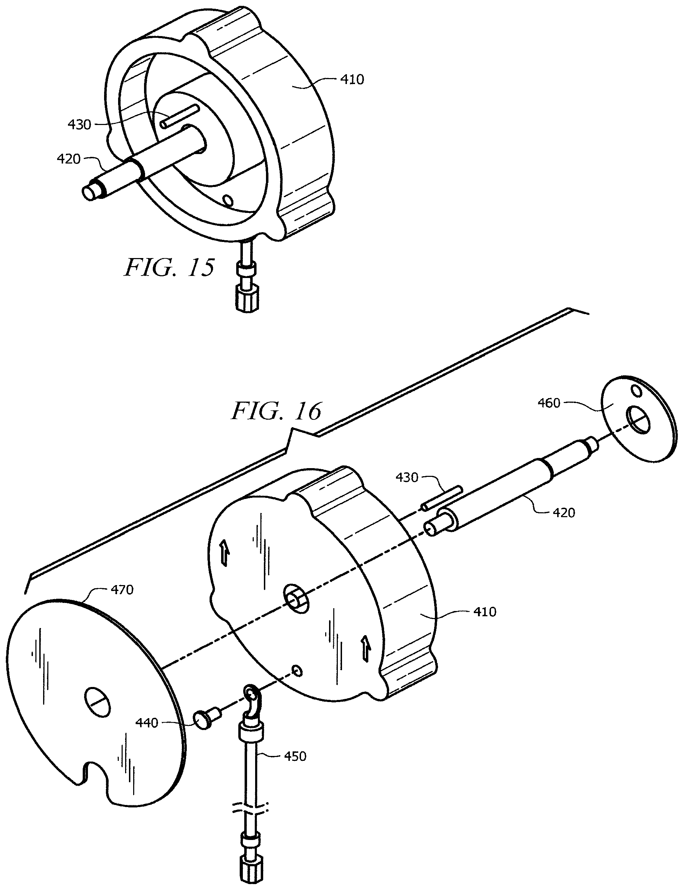

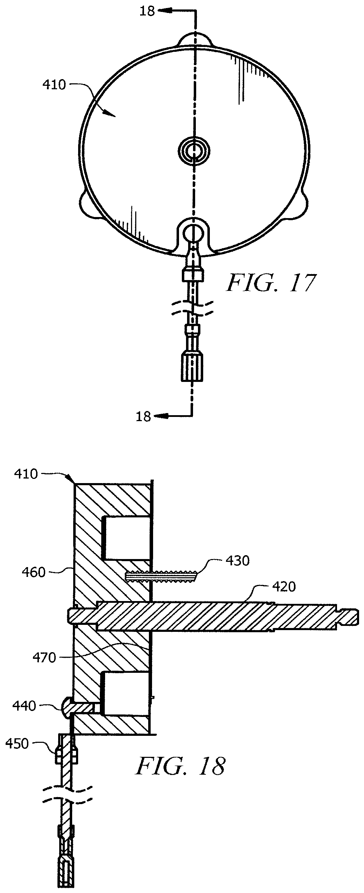

The clapper assembly (400), as best seen in FIGS. 15-18, comprises a clapper (410) with a shaft (420) and a spring pin (430) extending outward from a rear surface of the clapper (410). The shaft (420) is configured to extend from the housing (100), through an opening of the solenoid assembly (302) and seal (160) of the housing (100). The shaft (420) can thereby be reciprocated relative to the solenoid assembly (302) to actuate a diaphragm (62) of the pump (50). A ground wire assembly (450) is coupled to the clapper (410) by a fastener (440). A first shim (460) is coupled to a front surface of the clapper (410) and a second shim (470) is coupled to a rear surface of the clapper (410) to reduce friction and/or wear of the clapper (410). Still other suitable configurations for the EPU assembly (300) will be apparent to one with ordinary skill in the art in view of the teachings herein.

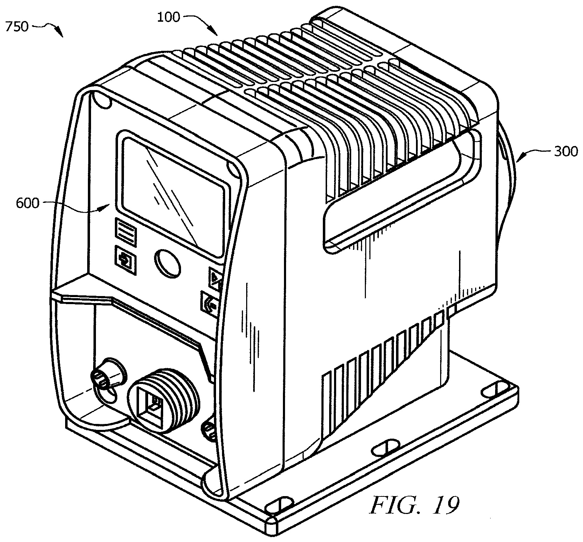

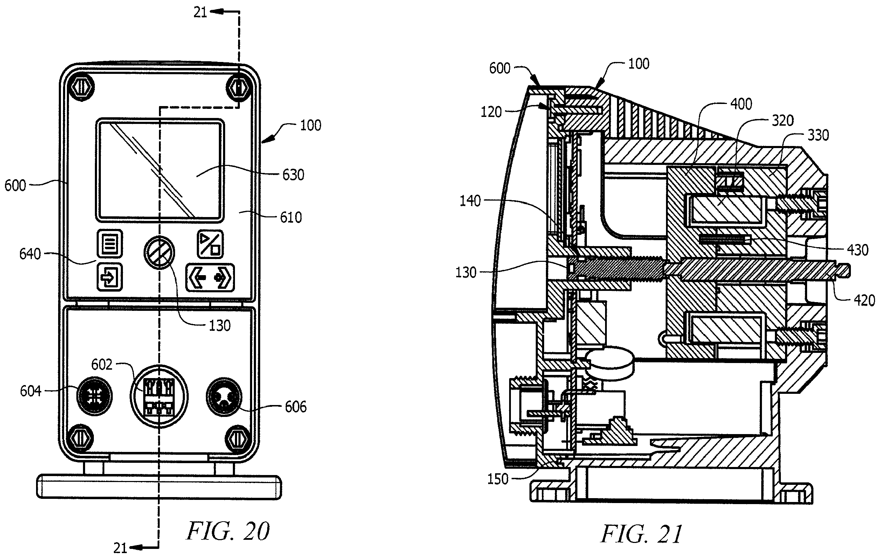

Another embodiment of a metering pump (750) is shown in FIGS. 19-21. The metering pump (750) is similar to the metering pump (50) described above, except that the metering pump (750) comprises a digital control panel assembly (600). As best seen in FIG. 20, the digital control panel assembly (600) comprises an LCD screen (630) and a keypad (640) positioned on a front surface of the control panel (610). The LCD screen (630) can display the selected settings for the pump (750) to a user. The LCD screen (630) can be about a 2.4-inch color display, but other suitable configurations can be used. The keypad (640) can be used to enable and/or adjust the automatic priming sequence settings. The digital control assembly (600) further comprises a power input (602), an external control input (604), and a source tank input (606). The power input (602) can be used to couple a power source with the pump (750). The external control input (604) can be used to couple an external control with the pump (750) to remotely start/stop and/or pulse the metering pump (750). The source tank input (606) can be used to couple the pump (750) with a source tank sensor to detect a low level and/or an empty source tank (2). Accordingly, the pump (750) can automatically stop actuating if there is an insufficient amount of fluid in the source tank (2). The metering pump (750) can be incorporated into the metering pump system (10) shown in FIG. 1A. Still other configurations for pump (50, 750) will be apparent to one with ordinary skill in the art in view of the teachings herein.

### II. Operation of the Diaphragm Metering Pump

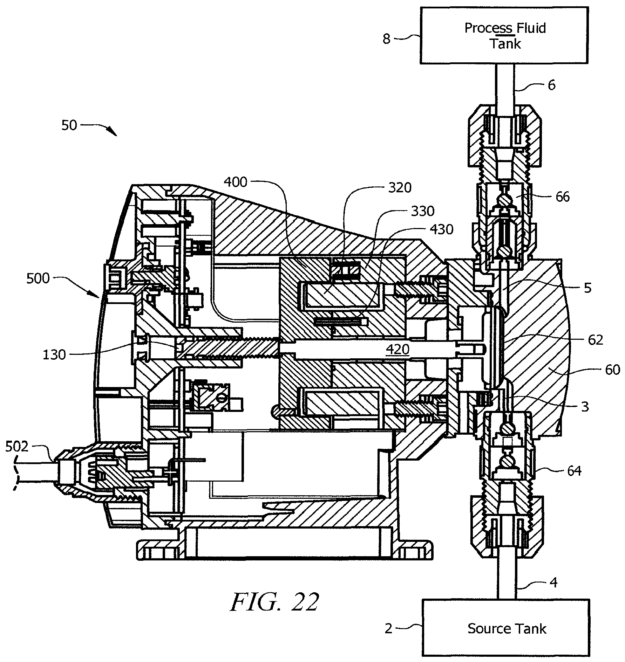

As discussed above, a metering pump (50) can be used to transfer fluid from a source tank (2) to a process fluid tank (8) for treatment. Referring to FIG. 22, the diaphragm metering pump (50) generally draws in the fluid from the source tank (2) to an inlet (3) at a first pressure, and discharges the fluid through an outlet (5) at a second pressure. During a suction stroke, the pump (50) creates a negative pressure scenario that lifts the fluid from the source tank (2) into the suction tube (4) toward the inlet (3), or suction end, of the pump (50). During the discharge stroke, the pump (50) creates a positive pressure differential to move the fluid towards the outlet (5), or discharge end, of the pump (50).

In the illustrated embodiment, the pump (50) is coupled to a pump chamber (60) and a diaphragm (62) is positioned between the pump (50) and the pump chamber (60) such that the diaphragm (62) is aligned with the shaft (420) of the clapper assembly (400). The shaft (420) thereby actuates the diaphragm (62) to create a reciprocating motion that leads to pressure changes within the pump chamber (60). The pump chamber (60) includes an inlet (3) and an outlet (5). The inlet (3) comprises a first check valve (64) and is fluidly coupled to the source tank (2) through suction tubing (4). The outlet (5) comprises a second check valve (66) and is fluidly coupled to the process fluid tank (8). The term "check valve" should be understood to mean a valve having a checking element configured to allow fluid to pass in one direction and arrest fluid flow in an opposing direction. Accordingly, the first check valve (64) allows fluid to enter the pump chamber (62) from the fluid source (2) during a suction stroke and prevents fluid from exiting through the inlet (3) during a pressure stroke. The second check valve (66) allows fluid to flow from the pump chamber (60) toward the process fluid tank (8) during a pressure stroke and prevents fluid from being ingested into the pump chamber (60) through outlet (5) during a suction stroke.

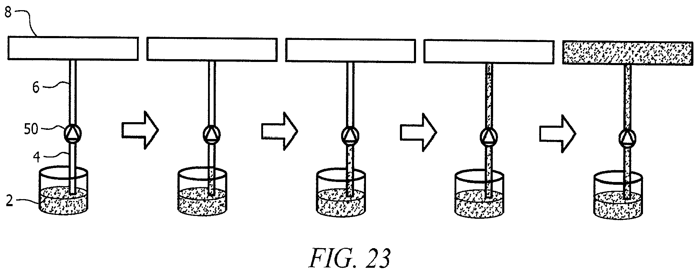

The initial priming sequence of the pump (50) is the process of filling the tubing (4, 6) with fluid such that the pumping system (10) is in an active state prepared to actively inject fluid into the fluid process tank (8). Typically, this priming process takes several pumping cycles of the pump (50) to fill the tubing (4, 6) adequately prior to being able to inject fluid into the process fluid tank (8), as shown in FIG. 23.

In some instances, the pump (50) may be subject to a loss of prime condition where a portion or all of the tubing (4, 6) is not filled with liquid. This may be caused by evacuated fluid, damaged diaphragms, gassing of the fluid, etc. During a loss of prime condition, the pressure vacuum in the tubing (4, 6) may be lost and the fluid may reverse flow from the tubing (4, 6) back into the source tank (2). This may occur if there is a leak in the system (10), in low duty cycle pumping applications, or if the pump (50) is turned off for an extended amount of time. When prime is lost in the system (10), the system (10) can be re-primed by actuating the pump (50) to return fluid to an adequate level. However, this re-priming may require manual intervention and may be time consuming due to low stroke frequency of the pump (50). This may result in under treating the process fluid because there may be several minutes of appropriate fluid treatment not occurring.

### III. Automatic Detection of Loss of Prime in a Metering Pump

Because it may be desirable to maintain fluid in the tubing (4, 6) of the pumping system (10) such that the pump (50) is in a primed condition, an automatic prime detection function is provided by monitoring the current of the solenoid assembly (302). For instance, monitoring the current feeding the coil (320) that engages the solenoid assembly (302) may allow for detection of loss of prime. Detection of loss of prime can trigger a priming mode to minimize the time required to re-prime the pumping system (10) and minimize the risk of under-dosing the process fluid. This can also eliminate the need for manual adjustments of the pump (50) to alleviate loss of prime, which is beneficial because typically the system (10) has already been in a prime loss state prior to manual intervention.

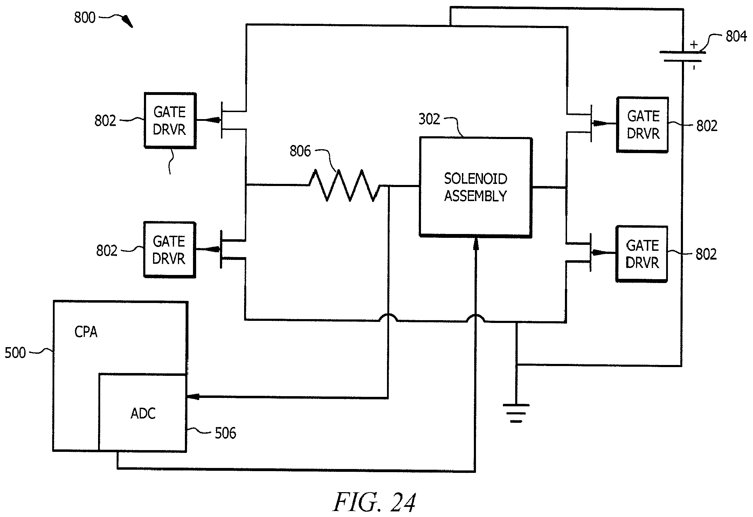

FIG. 24 illustrates an embodiment of a current monitoring circuit (800) that comprises a power source (804), a plurality of gate drivers (802), and a resistor (806). Power may be supplied to the circuit (800) by the power source (804). This power source (804) may be the same power source that provides power to the pump (50), or it may be a separate power source. The power source (804) thereby provides power to the gate drivers (802), which may amplify the current to drive the solenoid assembly (302). The current supplied by the current monitoring circuit (800) may be detected by the control panel assembly (500). In the illustrated embodiment, the current is measured between the resistor (806) and the solenoid assembly (302) through an analog-to-digital convertor (506), but other suitable configurations for the current monitoring circuit (800) can be used.

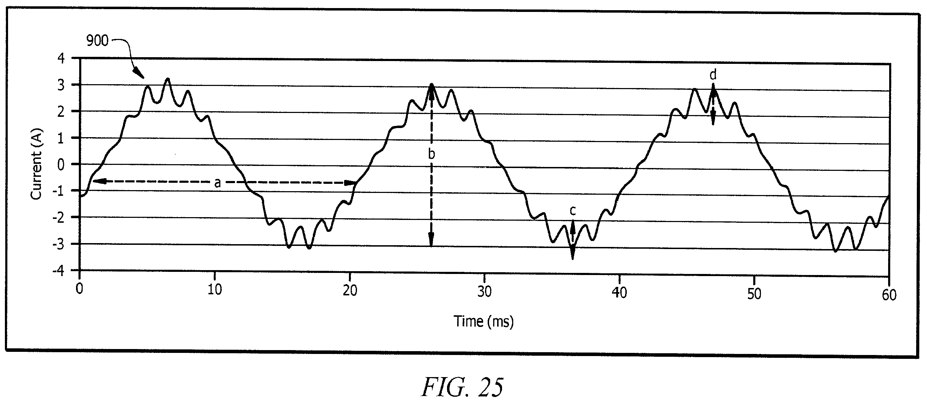

An example of a current waveform (900) that may be detected by the current monitoring circuit (800) is shown in FIG. 25 for illustrative purposes. This waveform (900) comprises waveform characteristics that may include, but is not limited to, a waveform shape, a period (a), an amplitude (b), noise levels (c, d), and slope (e). In the illustrated embodiment, the waveform (900) comprises a sinusoidal waveform shape with a period of about 20 ms and an amplitude of about 6 A. The noise levels (c, d) as shown in FIG. 25 are about 1 A, which can be monitored over time. Of course, the waveform (900) can have varying shapes, periods, amplitudes, and/or noise levels, and/or other suitable waveform characteristics. The circuit (800) can be used to monitor the solenoid current continuously, and/or for selected periods of time.

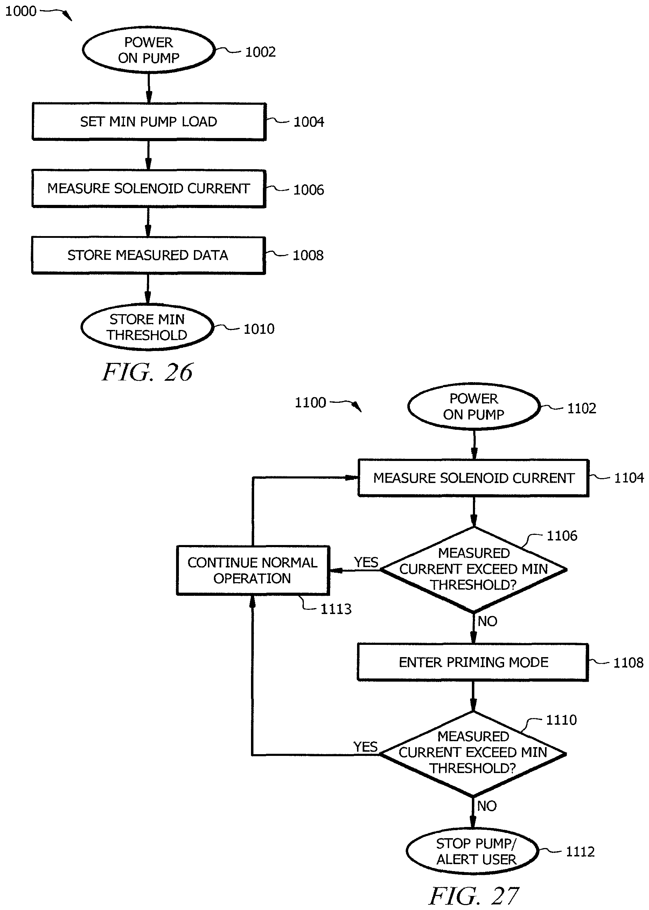

Once the current waveform (900) is detected by the circuit (800), the desirable waveform characteristics may be analyzed to determine a characterized or calculated waveform. A method (1000) of determining such a characterized waveform is shown in FIG. 26. For instance, the current required for the coil (320) to move the solenoid assembly (302) is dependent on the back pressure applied to the diaphragm (62). As liquid is evacuated from the pump end and replaced with air, resulting in a loss of prime condition, the back pressure applied to the diaphragm (62) and/or solenoid assembly (302) decreases. Below a desired threshold, a loss of prime condition and/or a damaged diaphragm (62) may have occurred. This selected current value may be repeatable across pumps (50) and may be characterized for comparison purposes.

Referring to FIG. 26, to characterize the selected current value, the pump (50) may be powered on (1002) and a selected pump load may be set (1004) to operate the solenoid assembly (302) at a desired level. The solenoid current can then be measured (1006) using the current monitoring circuit (800) described above. By monitoring the solenoid current, any repeatable and/or load dependent waveform characteristics can be identified. The measured data can be stored (1008), such as by the control panel assembly (500). The waveform characteristics of the solenoid current can then be analyzed. For instance, the waveform shape, period, amplitude, noise levels and/or slope of the waveform can be measured and stored to identify pump scenarios. Different topologies may have different behaviors to identify unloaded scenarios. From the monitored waveforms, a selected current value for the current to operate the solenoid assembly (302) under normal operating conditions can be determined and stored (1010), such as by the control panel assembly (500). A sample of pumps (50) may be used for comparison purposes to characterize a typical waveform for a pump (50). Accordingly, this selected current value can be set based on a selected pump load to operate the solenoid assembly (302) at a desired level, and/or a minimum threshold current can be used as the selected current value to operate the solenoid assembly (302) at a minimum pump load. Still other suitable methods for determining a characterized waveform and/or a selected current value will be apparent to one with ordinary skill in the art in view of the teachings herein.

A loss of prime condition can then be detected by comparing the measured current to the characterized current such that operation of the pump (50) can be changed based on load. A method (1100) for detecting such a loss of prime condition is shown in FIG. 27. The pump (50) can power on (1102) and the solenoid current can be measured (1104) using the current monitoring circuit (800) described above. The measured current can then be compared to the characterized current (1106). For instance, the waveform characteristics, such as shape, period, amplitude, noise levels, and/or slope, can be compared to determine if the measured current exceeds the selected current value determined by the characterized waveform.

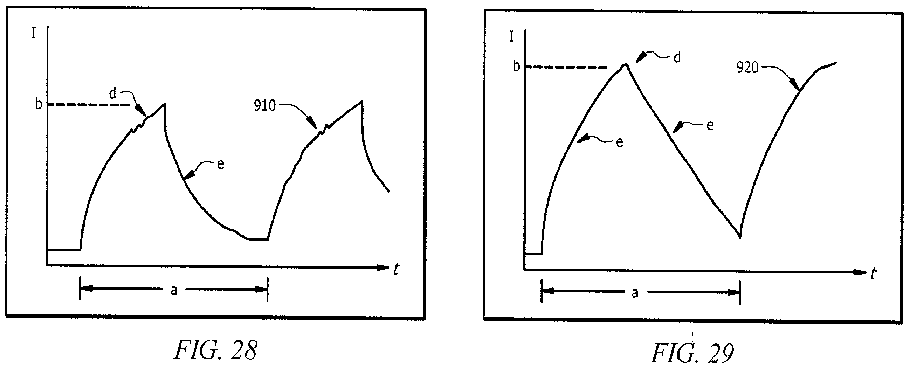

For instance, an example waveform (910) of a loaded pumping system (10) is shown in FIG. 28. Its waveform characteristics, such as waveform shape, period (a), amplitude (b), noise levels (d) and/or slope (e) of the waveform (910) can be measured and stored to identify pump scenarios. This loaded waveform (910) may have an amplitude (b) of about 1.5 A and a period (a) of about 300 ms. An example waveform (920) of an unloaded pumping system (10) that has lost prime is shown in FIG. 29. Its waveform characteristics, such as shape, period (a), amplitude (b), noise levels (d), and/or slope (e), can then be compared to determine if the measured current exceeds the selected current value determined by the characterized waveform based on the loaded waveform (910). This unloaded waveform (920) may have an amplitude (b) of about 1.2 A and a period (a) of about 300 ms. Accordingly, in this example, the amplitude (b) of the unloaded waveform (920) has decreased relative to the amplitude (b) of the loaded waveform (910). The noise level (d) and the slope (e) of the unloaded waveform (920) has also increased relative to the noise level (d) and the slope (e) of the loaded waveform (910). These waveform changes may thereby indicate a loss of prime condition. Of course, other suitable changes in the waveform characteristics, such as shape, period, amplitude, noise levels, and/or slope, can be used to indicate a loss of prime condition.

Referring back to FIG. 27, if the measured current does exceed the selected current value, the pump (50) can continue normal operation (1113). If the measured current does not exceed the selected current value, a loss of prime condition may have been detected and the pump (50) may enter a priming mode (1108). Accordingly, in an attempt to re-prime the pumping system (10), the control panel assembly (500) may maximize the stroke speed of the pump (50) for a selected amount of time. Of course, other suitable priming modes can be used. For instance, the pump (50) can be operated at any desirable speed during the priming mode, which can be adjustable. The pump (50) can also enter the priming mode for any selected amount of time, and/or until a primed condition is detected by the circuit (800). Further examples of such priming modes are described in U.S. Patent Application Serial No. 15/824,682, entitled "Automatic Initiation of Priming Sequence for Metering Pumps," filed on November 28, 2017, the disclosure of which is incorporated by reference herein.

After the priming mode, the measured current can again be compared to determine whether the measured current exceeds the selected current value (1110). If the measured current does exceed the selected current value such that the pumping system (10) has regained prime, the pump (50) can revert back to the pre-programmed stroke speed and continue normal operation (1113). If after the priming mode, the back pressure has not increased such that the measured current does not exceed the selected current value, the pump (50) may be operated in an alert mode where the pump may be stopped and/or a warning may be issued that a loss of prime condition has occurred (1112). Because an attempt to re-prime the system (10) has failed, the loss of prime condition may be due to a damaged diaphragm. Still other suitable methods for detecting a loss of prime condition will be apparent to one with ordinary skill in the art in view of the teachings herein.

Although the present invention and its advantages have been described in detail, it should be understood that various changes, substitutions and alterations can be made herein without departing from the spirit and scope of the invention as defined by the appended claims. Moreover, the scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. Accordingly, the appended claims are intended to include within their scope such processes, machines, manufacture, compositions of matter, means, methods, or steps.

## Claims

1. A method for detecting a loss of prime condition in a pumping system comprising the steps of:
characterizing at least one waveform characteristic of a current to a solenoid assembly that actuates a pump of the pumping system;
determining a selected current value needed to operate the solenoid assembly based on the characterized waveform;
measuring a current to the solenoid assembly; and
comparing the measured current to the selected current value.

2. The method of claim 1, wherein the at least one waveform characteristic comprises one or more of a shape, an amplitude, a period, a noise level, and a slope of the measured current.

3. The method of claim 1, wherein characterizing the at least one waveform characteristic comprises:
setting a selected pump load to operate the solenoid assembly at a desired level;
measuring the current to the solenoid assembly to determine the selected current value; and
storing the measured data in a control assembly.

4. The method of claim 1, wherein a loss of prime condition is detected when the measured current is below the selected current value.

5. The method of claim 4, further comprising operating the pump in a priming mode when the loss of prime condition is detected.

6. The method of claim 5, wherein the priming mode comprises actuating the pump at an elevated speed for a selected amount of time.

7. The method of claim 4, further comprising operating the pump in an alert mode when the loss of prime condition is detected by selecting one or more of stopping the pump and issuing a warning that the loss of prime condition has occurred.

8. The method of claim 1, further comprising continuing normal operation of the pump when the measured current is at or above the selected current value.

9. A pumping system comprising:
an electronic power unit comprising a solenoid assembly and a clapper assembly;
a diaphragm coupled to the electronic power unit, wherein the diaphragm is operable to pump fluid when the diaphragm is actuated by the electronic power unit; and
a control assembly coupled with the electronic power unit, wherein the control assembly is operable to actuate the electronic power unit;
wherein the control assembly is programmed to detect a loss of prime condition in the pumping system by measuring a current to the solenoid assembly.

10. The pump system of claim 9, wherein the control assembly is programmed to detect the loss of prime condition by comparing the measured current to a minimum threshold current needed to actuate the solenoid assembly at a minimum load.

11. The pump system of claim 9, wherein the control assembly is programmed to actuate the pump based on whether the loss of prime condition is detected.

12. The pump system of claim 11, wherein the control assembly is programmed to actuate the pump at a maximum capacity when the loss of prime condition is detected.

13. The pump system of claim 9 further comprising a current monitoring circuit operable to measure the current to the solenoid assembly.

14. The pump system of claim 13, wherein the current monitoring circuit comprises a resistor, wherein the monitoring circuit is operable to measure the current supplied to the solenoid assembly through the resistor.
